# EUROPEAN PATENT APPLICATION

(11) **EP 4 435 514 A1**
(43) Date of publication of application: **25.09.2024**
(21) Application number: 22896057.1
(22) Date of filing: 16.11.2022
(51) Int. Cl.: G03F 7/004, G03F 7/105, G03F 7/00, G03F 7/16, G03F 7/20, H10K 59/00

(54) **PHOTOSENSITIVE RESIN COMPOSITION, DISPLAY PANEL MANUFACTURED USING SAME, AND MANUFACTURING METHOD THEREFOR**

(30) Priority: 17.11.2021 KR 20210158711
(71) Applicant: Samsung Display Co., Ltd., Yongin-si, Gyeonggi-do 17113 (KR)
(72) Inventor: LEE, Ju Yon, Yongin-si Gyeonggi-do 17113 (KR); KANG, Jin Goo, Yongin-si Gyeonggi-do 17113 (KR); KOO, Young Mo, Yongin-si Gyeonggi-do 17113 (KR); HA, Jae Kook, Yongin-si Gyeonggi-do 17113 (KR); KIM, Se Hun, Yongin-si Gyeonggi-do 17113 (KR); SHIN, Jong Woo, Yongin-si Gyeonggi-do 17113 (KR)
(74) Representative: Dr. Weitzel & Partner
(86) International application number: PCT/KR2022/018100
(87) International publication number: WO 2023/090852

(57) **Abstract**

Provided is a photosensitive resin composition including a binder resin, a photopolymerizable monomer, a photopolymerization initiator, an active component, and a solvent, wherein the active component includes acyl hydrazide, alkyl carboxylic acid, organic hydroperoxide, or any combination thereof. Also provided are a display panel manufactured using the photosensitive resin composition described above, and a method of manufacturing the same.

## Description

### Technical Field

One or more embodiments relate to a photosensitive resin composition, a display panel manufactured using the same, and a method of manufacturing the display panel.

### Background Art

Light-emitting devices are devices that convert electrical energy into light energy. Examples of such light-emitting devices include an organic light-emitting device using an organic material for an emission layer, a quantum dot light-emitting device using quantum dots for an emission layer, and the like. Such a light-emitting device may be included in various electronic apparatuses, such as display apparatuses.

Some quantum dot light-emitting devices exhibit a positive aging effect in which characteristics of the quantum dot light-emitting devices improve with time. There is a need for suitable materials to achieve this positive aging effect.

### Disclosure

### Technical Problem

The task of the present invention is to provide a photosensitive resin composition that promotes a positive aging effect, a display panel manufactured using the same, and a method for manufacturing the same. However, these tasks are illustrative and do not limit the scope of the present invention.

### Technical Solution

According to one or more embodiments, a photosensitive resin composition includes a binder resin, a photopolymerizable monomer, a photopolymerization initiator, an active component, and a solvent, wherein the active component includes an acyl hydrazide, alkyl carboxylic acid, an organic hydroperoxide, or any combinations thereof.

In one or more embodiments, the active component may include benzhydrazide, isobutyric acid, cumene hydroperoxide, or any combinations thereof.

In one or more embodiments, an amount of the active component may be about 0.1 parts to about 1 part by weight based on 100 parts by weight of the photosensitive resin composition.

In one or more embodiments, the photosensitive resin composition may further include a liquid-repellent material.

According to one or more embodiments, a display panel includes: a light-emitting device on a substrate; and a bank layer formed using the photosensitive resin composition described above, wherein: the light-emitting device includes a pixel electrode, an interlayer arranged on the pixel electrode and including a quantum-dot emission layer, and a counter electrode arranged on the interlayer; the bank layer covers an edge portion of the pixel electrode and includes an opening overlapping the pixel electrode; and the interlayer is arranged in the opening.

In one or more embodiments, the counter electrode may cover the interlayer and the bank layer.

In one or more embodiments, the interlayer may further include a first region located between the pixel electrode and the quantum-dot emission layer, and a second region located between the quantum-dot emission layer and the counter electrode. The first region may be a hole transport region and the second region may be an electron transport region, or the first region may be an electron transport region and the second region may be a hole transport region.

In one or more embodiments, the light-emitting device may include the active component diffused from the bank layer.

In one or more embodiments, an upper surface and/or a lateral side of the bank layer may have liquid repellency.

In one or more embodiments, the quantum dot may include a Group II-VI semiconductor compound, a Group III-V semiconductor compound, a Group III-VI semiconductor compound, a Group I-III-VI semiconductor compound, a Group IV-VI semiconductor compound, a Group IV element or compound, or any combination thereof.

According to one or more embodiments, a method of manufacturing a display panel includes: forming a pixel electrode on a substrate; forming a bank layer on the pixel electrode using the photosensitive resin composition described above, the bank layer covering an edge portion of the pixel electrode and including an opening overlapping the pixel electrode; forming an interlayer arranged in the opening and including a quantum-dot emission layer; and forming a counter electrode on the interlayer, to thereby provide a light-emitting diode.

In one or more embodiments, the method may further include, after the providing of the light-emitting diode, diffusing the active component from the bank layer into the light-emitting diode.

In one or more embodiments, the diffusing of the active component may be carried out in a temperature range from about 50 °C to about 100 °C.

In one or more embodiments, the diffusing of the active component may be carried out in a time range from about 2 hours to about 48 hours.

In one or more embodiments, the diffusing of the active component may be carried out in an oxygen and/or hydrogen atmosphere.

In one or more embodiments, the forming of the bank layer may include: forming a photoresist layer on the pixel electrode using the photosensitive resin composition described above; exposing at least a portion of the photoresist layer; and developing the photoresist layer of which at least a portion is exposed, to thereby form the bank layer.

In one or more embodiments, the method may further include, after the forming of the bank layer, baking the bank layer.

In one or more embodiments, the method may further include, after the forming of the bank layer, plasma treatment of the bank layer.

In one or more embodiments, the quantum-dot emission layer is formed by a solution process.

In one or more embodiments, the quantum-dot emission layer is formed by inkjet printing.

### Advantageous Effects

As described above, according to the one or more embodiments, a display panel with improved efficiency may be provided. The scope of the present disclosure is not limited by such effects.

### Description of Drawings

FIG. 1 is a schematic perspective view of a display panel according to an embodiment; and
FIG. 2 is a cross-sectional view of a display panel according to an embodiment.

### Best Mode

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The present disclosure may, however, be embodied in many different forms and should not be construed as limited to the embodiments set forth herein.

Hereinafter, embodiments of the present disclosure will be described in detail with reference to the accompanying drawings. The same or corresponding components will be denoted by the same reference numerals, and thus redundant description thereof will be omitted.

An expression used in the singular encompasses the expression of the plural, unless it has a clearly different meaning in the context.

In Examples below, the prefix 'poly' refers to the plural number of 1 or more.

As used herein, the terms "comprise", "include", "have", and the like, specify the presence of stated features and/or components, and do not exclude the presence of addition of one or more other features and/or components.

It will be understood that when a layer, region, or component is referred to as being "on" or "onto" another layer, region, or component, it may be directly or indirectly formed on the other layer, region, or component. That is, for example, intervening layers, regions, or components may be present.

Sizes of components in the drawings may be exaggerated for convenience of explanation. In other words, because sizes and thicknesses of components in the drawings are arbitrarily illustrated for convenience of explanation, the following embodiments are not limited thereto.

As used hererin, the expression "A and/or B" indicates a case of A or B or a case of A and B. As used herein, the expression "at least one of A and B" indicates a case of A or B, or a case of A and B.

In the following examples, the expression "planar" may means a view from the top of a portion of interest, and "cross-sectional" may mean a view of a portion of interest from a cross-section of the portion cut in the vertical direction. In the following embodiments, the expression "overlapping" may include overlapping from a planar view and overlapping from a cross-sectional view.

When a certain embodiment is implemented differently, a specific process order may be performed differently from the described order. For example, two processes described in succession may be performed substantially simultaneously, or may be performed in an order opposite to the described order.

It will be understood that when a layer, region, or component is referred to as being "connected to" another layer, region, or component, the layer, region, or component may be directly connected to the another layer, region, or component, or indirectly connected to the another layer, region, or component as intervening layer, region, or component is present. For example, it will be understood that when a layer, region, or component is referred to as being "electrically connected to" another layer, region, or component, the layer, region, or component may be directly electrically connected to the another layer, region, or component, or indirectly electrically connected to the another layer, region, or component via intervening layer, region, or component.

In the present specification, the term "room temperature" refers to about 25 °C.

Hereinafter, embodiments of the disclosure will be described in detail with reference to the accompanying drawings. The same or corresponding components will be denoted by the same reference numerals.

### [Photosensitive resin composition]

The photosensitive resin composition includes a binder resin, a photopolymerizable monomer, a photopolymerization initiator, an active component, and a solvent.

The active component includes acyl hydrazide, alkyl carboxylic acid, an organic hydroperoxide, or any combinations thereof.

The active component may include benzhydrazide, isobutyric acid, cumene hydroperoxide, or any combinations thereof.

The active component may be derived from Loctite^{®} 366^{™}. Accordingly, in an embodiment, the photosensitive resin composition may further include Loctite^{®} 366^{™}.

An amount of the active component may be about 0.1 parts to about 1 part by weight based on 100 parts by weight of the photosensitive resin composition. When the amount of the active component satisfies the range described above, the occurrence of display defects of the photosensitive resin composition may be reduceed, and a positive aging effect may be facilitated.

The photosensitive resin composition further includes the active component as compared to a regular photosensitive resin composition used to form a bank layer of a display panel. Due to the diffusion of the active component in the photosensitive resin composition into a display panel, specifically, into a light-emitting device, the active component may promote a positive aging effect of the display panel. Typically, in order to promote a positive aging effect, it is necessary to perform additional processes, such as application of a resin composition, covering with a cover glass, and exposure. However, when the bank layer is formed using the photosensitive resin composition, the positive aging effect may be promoted without such additional processes. Accordingly, productivity of the display panel may be improved. In addition, formation of a bank layer using the photosensitive resin composition is a technology that is applicable even to a large-sized panel, and thus, the positive aging effect, which could limitedly be applied only in existing small and medium-sized panels, may be promoted even in large-sized panels.

The photosensitive resin composition includes a binder resin. The binder resin adjusts the viscosity of the photosensitive resin composition, and thus, improves close adhesion between a substrate and the bank layer formed using the photosensitive resin composition, and enables formation of a pattern with excellent surface smoothness during a development process.

The binder resin may be alkali soluble, but is not limited thereto. For example, the binder resin may include an acid anhydride residue or an acid dianhydride residue. An acid value of the binder resin may be about 5 mg KOH/g to about 60 mg KOH/g, for example, about 20 mg KOH/g to about 50 mg KOH/g. When the acid value of the binder resin is within the ranges described above, the resolution of a pattern may be excellent.

The binder resin may include a cardo-based binder resin, an acrylic binder resin, a polyimide-based resin, a polyurethane-based resin, or any combinations thereof.

An amount of the binder resin may be about 1 part to about 10 parts by weight, for example, about 3 parts to 8 parts by weight, based on 100 parts by weight of the photosensitive resin composition. When the amount of the binder resin satisfies the ranges described above, viscosity may be appropriately maintained, and thus, pattern formability, processibility, and/or developing ability may be excellent in pattern formation.

The photosensitive resin composition includes a photopolymerizable monomer. The photopolymerizable monomer forms a pattern through polymerization by exposure in a pattern formation process.

The photopolymerizable monomer may have, for example, at least one ethylenically unsaturated double bond.

For example, the photopolymerizable monomer may include a monofunctional ester of (meth)acrylic acid having at least one ethylenically unsaturated double bond, a multifunctional ester of (meth)acrylic acid having at least one ethylenicallyunsaturated double bond, or any combination thereof. When the photopolymerizable monomer has an ethylenicallyunsaturated double bond, sufficient polymerization is induced by exposure during the pattern formation process, thus enabling the formation of a pattern with excellent heat resistance, light resistance, and chemical resistance.

According to one or more embodiments, the photopolymerizable monomer may include ethylene glycol di(meth)acrylate, diethylene glycol di(meth)acrylate, triethylene glycol di(meth)acrylate, propylene glycol di(meth)acrylate, neopentyl glycol di(meth)acrylate, 1, 4-butanediol di(meth)acrylate, 1,6-hexanediol di(meth)acrylate, bisphenol A di(meth)acrylate, pentaerythritol di(meth)acrylate, pentaerythritol tri(meth)acrylate, pentaerythritol tetra(meth)acrylate, pentaerythritol hexa(meth)acrylate, dipentaerythritol di(meth)acrylate, dipentaerythritol tri(meth)acrylate, dipentaerythritol penta(meth)acrylate, dipentaerythritol hexa(meth)acrylate, bisphenol A epoxy(meth)acrylate, ethylene glycol monomethyl ether(meth)acrylate, trimethylol propane tri(meth) acrylate, tris(meth)acryloyloxyethyl phosphate, novolac epoxy(meth)acrylate, or any combinations thereof.

An amount of the photopolymerizable monomer may be about 0.5 parts to about 10 parts by weight, for example, 3 parts to 8 parts by weight, based 100 parts by weight of the photosensitive resin composition. When the amount of the photopolymerizable monomer satisfies the ranges described above, sufficient curing may occur during exposure, and thus, reliability and developing ability may be excellent.

The photosensitive resin composition includes a photopolymerization initiator. The photopolymerization initiator is to accelerate polymerization and improve a curing speed, and any photopolymerization initiator known in the art may be used without particular limitation.

The photopolymerization initiator may include an oxime-based compound, an acetophenone-based compound, a thioxanthone-based compound, a benzoin-based compound, and a benzophenone-based compound, or any combinations thereof.

The oxime-based compound may include 1,2-octanedione, 2-dimethylamino-2-(4-methylbenzyl)-1 -(4-morpholin-4-yl-phenyl)-butan-1 -one, 1-(4-phenylsulfanyl)phenyl)-butane-1,2-dione-2-oxime-0-benzoate, 1-(4-phenylsulfanylphenyl)-octane-1,2-dione-2-oxime-0-benzoate, 1-(4-phenylsulfanylphenyl)-octane-1-oneoxime-0-acetate, 1-(4-phenylsulfanylphenyl)-butan-1-one-2-oxime-0-acetate, 2-(0-benzoyloxime)-1-[4-(phenylthio)phenyl]-1,2-octanedione, 1-(0-acetyloxime)-1-[9-ethyl-6-(2-methylbenzoyl)-9H-carbazol-3-yl]ethanone, 0-ethoxycarbonyl-α-oxyamino-1-phenylpropan-1-one, or any combinations thereof.

The acetophenone-based compound may include 4-phenoxy dichloroacetophenone, 4-t-butyl dichloroacetophenone, 4-t-butyl trichloroacetophenone, 2,2-diethoxyacetophenone, 2-hydroxy-2-methyl-1-phenyl-propan-1-one, 1-(4-isopropylphenyl)-2-hydroxy-2-methyl-propan-1-one, 1-(4-dodecylphenyl)-2-hydroxy-2-methylpropan-1-one, 4-(2-hydroxyethoxy)-phenyl-(2-hydroxy-2-propyl)ketone, 1-hydroxycyclohexyl phenyl ketone, 2-methyl-1-[4-(methylthio)phenyl]-2-morpholino-propan-1-one, or any combinations thereof.

The thioxanthone-based compound may include thioxanthone, 2-chlorothioxanthone, 2-methylthioxanthone, isopropyl thioxanthone, 2,4-diethyl thioxanthone, 2,4-diisopropyl thioxanthone, or any combinations thereof.

The benzoin-based compound may include benzoin, benzoin methyl ether, benzoin ethyl ether, benzoin isopropyl ether, benzoin isobutyl ether, benzyldimethyl ketal, or any combinations thereof.

The benzophenone-based compound may include benzophenone, benzoyl benzoic acid, benzoyl benzoic acid methyl ester, 4-phenyl benzophenone, hydroxyl benzophenone, 4-benzoyl-4'-methyl diphenyl sulfide, 3,3'-dimethyl-4-methoxy benzophenone, or any combinations thereof.

An amount of the photopolymerization initiator may be about 0.1 parts by weight to about 5 parts by weight, for example, about 0.5 parts by weight to about 1 part by weight, based on 100 parts by weight of the total weight of the photosensitive resin composition. When the amount of the photopolymerization initiator satisfies the ranges described above, a sufficiently fast work speed may be obtained, and non-uniformity of film due to an excessively fast curing reaction may be reduced.

The photosensitive resin composition may include a solvent. The solvent may be a material that is miscible with other components of the photosensitive resin composition but does not react with the same.

Examples of the solvent include compounds, including: alcohols, such as methanol and ethanol; ethers, such as dichloroethyl ether, n-butyl ether, diisoamyl ether, methylphenyl ether, and tetrahydrofuran; glycol ethers, such as ethylene glycol methyl ether, ethylene glycol ethyl ether, and propylene glycol monomethyl ether; cellosolve acetates, such as methyl cellosolve acetate, ethyl cellosolve acetate, and diethyl cellosolve acetate; carbitols, such as methylethyl carbitol, diethyl carbitol, diethylene glycol monomethyl ether, diethylene glycol monoethyl ether, diethylene glycol dimethyl ether, diethylene glycol methyl ethyl ether, and diethylene glycol diethyl ether; propylene glycol alkyl ether acetates, such as propylene glycol methyl ether acetate, propylene glycol monoethyl ether acetate, and propylene glycol propyl ether acetate; aromatic hydrocarbons, such as toluene and xylene; ketones, such as methyl ethyl ketone, cyclohexanone, 4-hydroxy-4-methyl-2-pentanone, methyl-n-propyl ketone, methyl-n-butyl kenone, methyl-n-amyl ketone, and 2-heptanone; saturated aliphatic monocarboxylic acid alkyl esters, such as ethyl acetate, n-butyl acetate, and isobutyl acetate; lactic acid alkyl esters, such as methyl lactate and ethyl lactate; hydroxyacetic acid alkyl esters, such as methyl hydroxyacetate, ethyl hydroxyacetate, and butyl hydroxyacetate; acetic acid alkoxyalkyl esters, such as methoxymethyl acetate, methoxyethyl acetate, methoxybutyl acetate, ethoxymethyl acetate, and ethoxyethyl acetate; 3-hydroxypropionic acid alkyl esters, such as methyl 3-hydroxypropionate and ethyl 3-hydroxypropionate; 3-alkoxypropionic acid alkyl esters, such as methyl 3-methoxypropionate, ethyl 3-methoxypropionate, ethyl 3-ethoxypropionate, and methyl 3-ethoxypropionate; 2-hydroxypropionic acid alkyl esters, such as methyl 2-hydroxypropionate, ethyl 2-hydroxypropionate, and propyl 2-hydroxypropionate; 2-alkoxypropionic acid alkyl esters, such as methyl 2-methoxypropionate, ethyl 2-methoxypropionate, ethyl 2-ethoxypropionate, and methyl 2-ethoxypropionate; 2-hydroxy-2-methylpropionic acid alkyl esters, such as methyl 2-hydroxy-2-methylpropionate and ethyl 2-hydroxy-2-methylpropionate; 2-alkoxy-2-methylpropionic acid alkyl esters, such as methyl 2-methoxy-2-methylpropionate and ethyl 2-ethoxy-2-methylpropionate; esters, such as 2-hydroxyethyl propionate, 2-hydroxy-2-methylethyl propionate, hydroxyethyl acetate, and methyl 2-hydroxy-3-methylbutanoate; or ketonic acid esters, such as ethyl pyruvate. Also, examples of the solvent may include N-methylformamide, N,N-dimethylformamide, N-methylformanilide, N-methylacetamide, N,N-dimethylacetamide, N-methylpyrrolidone, dimethyl sulfoxide, benzylethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl cellosolve acetate, or any combination thereof.

An amount of the solvent may be about 70 parts to about 98 parts by weight based on 100 parts by weight of the photosensitive resin composition. When the amount of the solvent satisfies the range described above, the photosensitive resin composition may have appropriate viscosity, and thus, excellent processability.

In an embodiment, the photosensitive resin composition may further include various additives, and thus, the photosensitive resin composition may have various modifications. In particular, the photosensitive resin composition may include, as additives, a liquid-repellent material, a surfactant, an adhesion enhancer, a sensitizer, a stabilizer, or any combinations thereof.

The photosensitive resin composition may further include a liquid-repellent material in order to improve liquid repellency.

The liquid-repellent material may include a fluorine resin.

An amount of the liquid-repellent material may be about 0.01 parts by weight to about 5 parts by weight, for example, about 0.1 parts by weight to about 2 parts by weight, based on 100 parts by weight of the photosensitive resin composition.

In some embodiments, the photosensitive resin composition may further include a surfactant, for example, a fluorine-based surfactant or a silicone-based surfactant, in order to improve coating characteristic and leveling performance.

The fluorine-based surfactant may have a weight average molecular weight in a range of about 4,000 g/mol to about 10,000 g/mol, for example, about 6,000 g/mol to about 10,000 g/mol. In addition, the fluorine-based surfactant may have a surface tension in a range of about 18 mN/m to about 23 mN/m (measured in 0.1 % propylenglycol monomethylether acetate (PGMEA) solution). When the weight average molecular weight and the surface tension of the fluorine-based surfactant are within these ranges, leveling performance may be further improved, occurrence of stains during coating may be prevented, and relatively less bubbles are generated, resulting in fewer film defects.

Commercially available examples of the fluorine-based surfactant include: for example, MEGAFACE^{®} product line manufactured by DIC Company, such as F-114, F-251, F-253, F-281, F-410, F-430, F-477, F-510, F-551, F-552, F-553, F-554, F-555, F-556, F-557, F-558, F-559, F-560, F-561, F-562, F-563, F-565, F-568, F-569, F-570, F-572, F-574, F-575, F-576, R-4, R-41, R-94, RS-56, RS-72-K, RS-75, RS-76-E, RS-76-NS, RS-78, RS-90, or DS-21; Fluorosurfactant ^{®} product line manufactured by 3M Company, such as FC-135, FC-170C, FC-430, FC-431, FC-4430, or FC-4433; SURFLON ^{®} product line manufactured by AGC Company, such as S-211, S-221, S-231, S-232, S-241, S-242, S-243, S-420, S-431, S-386, S-611, S-647, S-651, S-653, S-656, S-658, F693; or CPASTONE^{®} product line manufactured by DuPONT Company, such as FS-30, FS-65, FS-31, FS-3100, FS-34, FS-35, FS-50, FS-51, FS-60, FS-61, FS-63, FS-64, FS-81, FS-22, or FS-83; and the like, but embodiments of the present disclosure are not limited thereto.

For example, the surfactant may include a silicon-based surfactant. Commercially available examples of the silicon-based surfactant include: for example, DYNOL^{™} product line manufactured by Evonik Company, such as DYNOL^{™} 360, DYNOL^{™} 604, DYNOL^{™} 607, DYNOL^{™} 800, or DYNOL^{™} 810, and TEGO^{®} product line manufactured by the same company, such as Twin 4000, Twin 4100, or Twin 4200; BYK-300, BYK-301, BYK-302, BYK-306 , BYK-307, BYK-310, BYK-313, BYK-315N, BYK-320, BYK-322, BYK-323, BYK-325N, BYK-326, BYK-327, BYK-329, BYK-330, BYK-331, BYK-332, BYK-333, BYK-342, BYK-345, BYK-346, BYK-347, BYK-348, BYK-350, BYK-352, BYK-354, BYK-355, BYK-356, BYK-358N, BYK-359, BYK-360P, BYK-361N, BYK-364P, BYK-366P, BYK-368P, BYK-370, BYK-375, BYK-377, BYK-378, BYK-381, BYK-390, BYK-392, or BYK-394 manufactured by BYK Company; and the like, but embodiments of the present disclosure are not limited thereto.

An amount of the surfactant may be, for example 0.01 parts by weight to about 5 parts by weight, for example, about 0.1 parts by weight to about 2 parts by weight, based on 100 parts by weight of the photosensitive resin composition.

In some embodiments, the photosensitive resin composition may further include an adhesion enhancer.

The adhesion enhancer may include, for example, a titanium-based adhesion enhancer, an aluminum-based adhesion enhancer, or a silane-based adhesion enhancer.

Examples of the silane-based adhesion enhancer are: an epoxy-based silane binder, such as 3-glycidyloxypropyl trimethoxysilane, 3-glycidyloxypropyl triethoxysilane, 3-glycidyloxypropyl (dimethoxy)methylsilane, or 2-(3,4-epoxycyclohexyl)ethyl trimethoxysilane; a mercapto-based silane binder, such as 3-mercaptopropyl trimethoxysilane, 3-mercaptopropyl triethoxysilane, 3-mercaptopropyl methyldimethoxysilane, or 11-mercaptoundecyl trimethoxysilane; an amino-based silane binder, such as 3-aminopropyl trimethoxysilane, 3-aminopropyl triethoxysilane, 3-aminopropyl dimethoxymethylsilane, N-phenyl-3-aminopropyl trimethoxysilane, N-methylaminopropyl trimethoxysilane, N-(2-aminoethyl)-3-aminopropyl trimethoxysilane, or N-(2-aminoethyl)-3-aminopropyl dimethoxymethylsilane; a ureide-based silane binder, such as 3-ureido propyl triethoxysilane; a vinyl-based silane binder, such as vinyl trimethoxysilane, vinyl triethoxysilane, or vinyl methyldiethoxy silane; a styryl-based silane binder, such as p-styryl trimethoxysilane; an acrylate-based silane binder, such as 3-acryloxypropyl trimethoxysilane or 3-metacryloxypropyl trimethoxysilane; an isocyanate-based silane binder such as 3-isocyanate propyl trimethoxysilane; a sulfide-based silane binder, such as bis(triethoxysilylpropyl)disulfide or bis(triethoxysilylpropyl)tetrasulfide; phenyl trimethoxysilane; metacryloxypropyl trimethoxysilane; imidazolesilane; triazinesilane; and the like, but embodiments of the present disclosure are not limited thereto. Commercially available examples of the adhesion enhancer are KBM-1003, KBE-1003, KBM-303, KBM-402, KBM-403, KBE-402, KBE-403, KBM-1403, KBM-502, KBM-503, KBE-502, KBE-503, KBM-5103, KBM602, KBM-603, KBM-903, KBE-903, KBE-9103P, KBM-573, KBM-575, KBE-585, KBE-9007N, KBM-9659, KBM-802, or KBM-803 manufactured by Shin Etsu Company; SIA02000.0, SIS6964.0, SIA08591.0, SIS6964.0, SIB1824.5, SIA0591.0, SIT8192.6, SIG5840.0, SIB1834.0, SIE4668.0, SIA0599.2, SIC2295.5, SIB1833.0, SIA0611.0, SIG5840.0, SIB1140.0, SIB1833.0, SIS6990.0, SIB1832.0, SIE4670.0, SIM6487.4, SIB1828.0, SIM6487.4, SIS6994.0, SIB1140.0, SIM6476.0, SIU9058.0, SII6455.0, SIT8717.0, SSP-055, SIA0780.0, or VEE-005 manufactured by Gelest Company; SA6112C, SA1003O, SA0004O, SA3003O, SA4003O, SA1003M, SB1003M, SB1013E, SB1022M, SB2003M, or SB3003M manufactured by KCC Company; and the like, but embodiments of the present disclosure are not limited thereto.

In addition, an amount of the adhesion enhancer may be about 0.1 parts to about 10 parts by weight, for example, about 0.5 parts to about 5 parts by weight, based on 100 parts by weight of the total weight of the first monomer and the second monomer in the photosensitive resin composition. In other embodiments, the amount of the adhesion enhancer may be about 0.1 parts to about 10 parts by weight, for example, about 0.5 parts to about 5 parts by weight, based on 100 parts by weight of the total amount of the first monomer and the second monomer in the photosensitive resin composition. In other embodiments, the amount of the adhesion enhancer may be in a range of about 0.1 parts by weight to about 10 parts by weight, for example, about 0.5 parts by weight to about 5 parts by weight, based on 100 parts by weight of the total amount of the first monomer, the second monomer, and the third monomer in the photosensitive resin composition.

In some embodiments, the photosensitive resin composition may further include a sensitizer. The sensitizer may further improve polymerization initiation efficiency of the polymerization initiator, and thus may serve to further accelerate a curing reaction of the photosensitive resin composition.

The sensitizer may supplement curability with rays having a long wavelength of 300 nm or more. The sensitizer may be a compound that absorbs light having a wavelength in a range of about 250 nm to about 405 nm, about 300 nm to about 405 nm, or about 350 nm to about 395 nm.

Examples of the sensitizer are: an anthracene-based compound, such as 9,10-dimethoxyanthracene, 9,10-diethoxyanthracene, 9,10-dibutoxyanthracene, or 2-ethyl-9,10-dimethoxyanthracene; a benzophenone-based compound, such as 4,4-bis(dimethylamino)benzophenone, 4,4-bis(diethylamino) benzophenone, 2,4,6-trimethylaminobenzophenone, methyl-o-benzoylbenzoate, 3,3-dimethyl-4-methoxybenzophenone, or 3,3,4,4-tetra(t-butylperoxycarbonyl)benzophenone; a ketone-based compound, such as dimethoxyacetophenone, diethoxy acetophenone, 2-hydroxy-2-methyl-1-phenylpropane-1-one, or propanone; a fluorenone-based compound, such as 9- fluorenone, 2-chloro-9- fluorenone, or 2-methyl-9- fluorenone; a thioxanthone-based compound, such as thioxanthone, 2,4-diethyl thioxanthone, 2-chloro thioxanthone, 1-chloro-4-propyloxy thioxanthone, isopropyl thioxanthone (ITX), or diisopropyl thioxanthone; a xanthone-based compound, such as xanthone or 2-methyl xanthone; an anthraquinone-based compound, such as anthraquinone, 2-methyl anthraquinone, 2-ethyl anthraquinone, t-butyl anthraquinone, or 2,6-dichloro-9,10-anthraquinone; an acridine-based compound, such as 9-phenylacridine, 1,7-bis(9-acrydinyl)heptane, 1,5-bis(9-acrydinylpentane), or 1,3-bis(9-acrydinyl)propane; a dicarbonyl compound, such as benzyl, 1,7,7-trimethyl-bicyclo[2,2,1]heptane-2,3-dione, or 9,10-phenanthrenequinone; a phosphine oxide-based compound, such as 2,4,6-trimethylbenzoyl diphenylphosphine oxide or bis(2,6-dimethoxybenzoyl)-2,4,4-trimethylpentyl phosphine oxide; a benzoate-based compound, such as methyl-4-(dimethylamino)benzoate, ethyl-4-(dimethylamino) benzoate, or 2-n-butoxyethyl-4-(dimethylamino)benzoate; an amino-based compound, such as 2,5-bis(4-diethylaminobenzal)cyclopentanone, 2,6-bis(4-diethylaminobenzal)cyclohexanone, or 2,6-bis(4-diethylaminobenzal)-4-methyl-cyclopentanone; a coumarin-based compound, such as 3,3-carbonylvinyl-7-(diethylamino)coumarin, 3-(2-benzothiazolyl)-7-(diethylamino)coumarin, 3-benzoyl-7-(diethylamino)coumarin, or 3-benzoyl-7-methoxy-coumarin; a chalcone compound, such as 4-diethylamino chalcone or 4-azidebenzalacetophenone; 2-benzoylmethylen; 3-methyl-beta-naphthothiazoline; and the like, but embodiments of the present disclosure are not limited thereto.

An amount of the sensitizer may be in a range of about 0.05 parts by weight to about 3 parts by weight, for example, about 0.1 parts by weight to about 1 parts by weight, based on 100 parts by weight of the photosensitive resin composition. When the amount of the sensitizer is within these ranges, a sufficient sensitization effect may be obtained, and light may be transmitted to a deep part.

In an embodiment, the photosensitive resin composition may further include a stabilizer, for example, an antioxidant, a UV absorber, and/or an anti-aggregation agent. The stabilizer may be used to increase the period of use of the photosensitive resin composition.

Examples of the antioxidant are 2,6-di-t-butyl-4-methylphenol, 3,5-di-t-butyl-4-hydroxybenzaldehyde, 2-t-butyl-4-methoxyphenol, 1,3,5-tris[(4-t-butyl-3-hydroxy-2,6-dimethylphenyl)methyl]-1,3,5-triazine-2,4,6-trione, [3-[3-(3,5-di-t-butyl-4-hydroxyphenyl)propanoyloxy]-2,2-bis[3-(3,5-di-t-butyl-4-hydroxyphenyl)propanoyloxymethyl]propyl]3-(3,5-di-t-butyl-4-hydroxyphenyl)propanoate, [3-[3-(3,5-dit-butyl-4-hydroxyphenyl)propanoyloxy]-2,2-bis[3-(3,5-dit-butyl-4-hydroxyphenyl)propanoyloxymethyl]propyl]3-(3,5-di-t-butyl-4-hydroxyphenyl)propanoate, octadecyl-3-(3,5-di-t-butyl-4-hydroxyphenyl)propanoate, tris(2,4-di-t-butylphenyl)phosphite, (4,4'-thio-bis(2-t-butyl-5-methylphenol, 2,2'-thiobis(4-methyl-6-t-butylphenol), 2,6-di-t-butyl-4-methylphenol, and the like, but embodiments of the present disclosure are not limited thereto.

Examples of the UV absorber are 2-(3-t-butyl-2-hydroxy-5-methylphenyl)-5-chlorobenzotyriazole, alkoxybenzophenone bis(2,2,6,6-tetramethylpiperidine-4-yl)decandionate, 2-hydroperoxy-2-methylpropane, bis(3,3,5,5-tetramethylpiperidine-4-yl)decandionate, 4-methylhexyl-3-[3-(benzotyriazole-2-yl)-5-t-butyl-4-hydroxyphenyl]propanoate), and the like, but embodiments of the present disclosure are not limited thereto.

Examples of the anti-aggregation agent are polyacrylic acid sodium and the like, but are embodiments of the present disclosure are not limited thereto.

An amount of the stabilizer may be in a range of about 0.05 parts to about 10 parts by weight, for example, about 0.1 parts to about 5 parts by weight, and for example, about 0.1 parts to about 3 parts by weight, based on 100 parts by weight of the photosensitive resin composition.

### [Display panel]

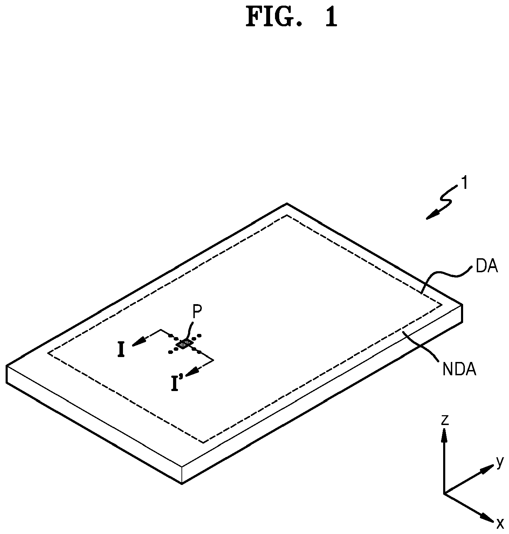

FIG. 1 is a schematic perspective view of a display panel according to an embodiment.

Referring to FIG. 1, a display panel 1 according to an embodiment may include a display area (DA), and a non-display area (NDA) arranged on the periphery of the display area (DA). The non-display area (NDA) may surround the display area (DA). The display panel 1 may provide images using light emitted from a plurality of pixels P arranged in the display area (DA), and the non-display area (NDA) may be an area in which no image is displayed.

Hereinafter, although the following embodiments are described with reference to a quantum dot light-emitting display panel as an embodiment of the display panel 1 according to embodiments of the present invention, embodiments of the display panel of the present invention are not limited thereto. In one or more embodiments, the display panel 1 of the present invention may be a display panel such as an inorganic light-emitting display panel or an organic light-emitting display panel. For example, an emission layer of a display element provided in the display panel 1 may include an organic material or an inorganic material, or may include a quantum dot or an organic material and a quantum dot, or an inorganic material and a quantum dot.

Although the display panel 1 provided with a flat display surface is illustrated in FIG. 1, the present invention is not limited thereto. In one or more embodiments, the display panel 1 may include a 3D display surface or a curved display surface.

When the display panel 1 includes a 3D display surface, the display panel 1 may include a plurality of display areas directing different directions, and may include, for example, a polygonal columnar display surface. In one or more embodiments, when the display panel1 includes a curved display surface, the display panel 1 may be implemented in various forms, for example, as a flexible, foldable, or rollable display device.

FIG. 1 shows a display panel 1 that can be applied to a mobile phone terminal. Although not illustrated, a mobile phone terminal may be configured by arrangement of electronic modules, a camera module, a power module, and the like, which are mounted on a main board, in a bracket/case or the like along with the display panel 1. In particular, the display panel 1 according to embodiments may be applied, in addition to large electronic devices such as televisions, monitors, or the like, to medium and small electronic devices, such as tablets, car navigations, game machine, smart watches, and the like.

Although FIG. 1 illustrates a case where the display area (DA) of the displaypanel 1 is rectangular, the display area (DA) may have a circular shape, an elliptical shape, or a polygonal shape like a triangle or pentagon.

The display panel 1 may include a plurality of pixels P arranged in the display area (DA). The plurality of pixels (P) may each include an organic light-emitting diode (OLED). The plurality of pixels (P) may each emit for example, red, green, blue, or white light through the organic light-emitting diode (OLED). As used herein, the pixel may be understood as a pixel that emits light of any one color of red, green, blue, and white.

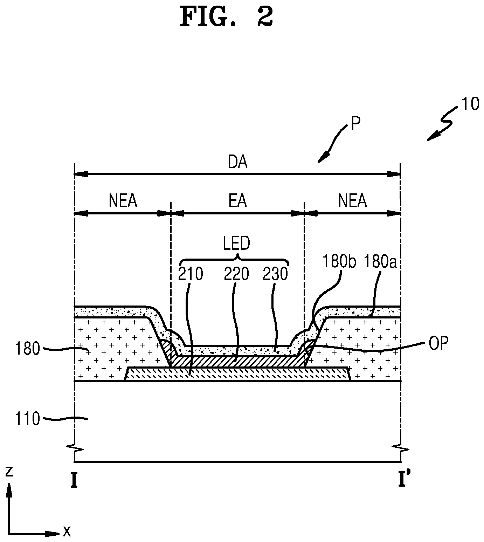

FIG. 2 is a cross-sectional view of a display device according to an embodiment. In particular, FIG. 2 shows a cross-section taken along line I-I' of FIG. 1.

Referring to FIG. 2, the display device 10 may include a substrate 100 and a light-emitting diode (LED) arranged on the substrate 100.

Hereinafter, the display device 10 according to embodiments will be described according to the stacking order.

The substrate 100 may include a glassa material, a ceramic material, a metal material, or a material having flexible or bendable characteristics. The substrate 100 may such a material in a single layer or multilayer structure. When the substrate 100 has a multilayer structure, an inorganic layer may be further included. In one or more embodiments, the substrate may have a structure of organic material/inorganic material/organic material.

A thin film transistor (TFT) (not shown) may be arranged on the substrate 100. The thin film transistor (TFT) may include a semiconductor layer, a gate electrode overlapping the semiconductor layer, and a connection electrode electrically connected to the semiconductor layer. The thin film transistor (TFT) may be electrically connected to the light-emitting diode (LED) and drive the light-emitting diode (LED).

The light-emitting diode (LED) including a pixel electrode 210, an interlayer 220, and a counter electrode 230 may be arranged on the TFT.

The pixel electrode 210 may be a (semi-) transmissive electrode or a reflective electrode. The pixel electrode 210 may include: a reflective film, which is formed of aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), copper (Cu), or a compound thereof; and a transparent or semi-transparent electrode layer on the reflective film. The transparent or semi-transparent electrode layer may include at least one selected from the group consisting of indium tin oxide (ITO), indium zinc oxide (IZO), zinc oxide (ZnO), indium oxide (In₂O₃), indium gallium oxide (IGO), and aluminum zinc oxide (AZO). The pixel electrode 210 may be provided as a stacked structure of ITO/Ag/ITO.

A bank layer 180 may be arranged on the substrate 100, and may cover an edge portion of the pixel electrode 210 and have an opening (OP) overlapping the pixel electrode 210. A region of the bank layer 180 that is exposed through the opening (OP) of the bank layer 180 may be defined as an emission area (EA). The periphery of an emission area (NEA) is a non-emission area (NEA), and may surround the emission area (EA). That is, the display area (DA) may include a plurality of emission areas (EAs), and non-emission areas (NEA) surrounding the emission areas (EAs). The bank layer 180 may increase the distance to the counter electrode 230 on the pixel electrode 210, and thus may prevent the occurrence of an arc at the edge of the pixel electrode 210. The bank layer 180 may be formed using the photosensitive resin composition described above. For details of the photosensitive resin composition, the above descriptions of the photosensitive resin composition may be referred to.

The bank layer 180 may have liquid repellency. In one or more embodiments, an upper surface 108a of the bank layer 180 may have liquid repellency. As used herein, having liquid repellency means that, in an inkjet process, a contact angle to a solvent constituting an ink including an organic material forming the interlayer 220, which will be described later, or a contact angle to the ink including the organic material, is about 90 degrees or greater. That is, having liquid repellency means that, in an inkjet process, a contact angle to a solvent constituting an ink including an organic material forming the interlayer 220, or a contact angle to the ink including the organic material, is relatively large. Due to the upper surface 180a of the bank layer 180 having liquid repellency, the non-emission region (NEA) may be prevented from being coated with the ink including the organic material, or such coating may be minimized. In other embodiments, a lateral side 180b of the bank layer 180 may have liquid repellency.

The interlayer 220 may be arranged on the pixel electrode 210 of which at least a portion is exposed through the bank layer 180. That is, the interlayer 220 may be arranged in the opening (OP) defined by the bank layer 180.

The interlayer 130 refers to a single layer and/or a plurality of layers arranged between the pixel electrode 210 and the counter electrode 230 in the light-emitting device (LED). A material included in the interlayer 130 may be an organic material and/or an inorganic material.

In one or more embodiments, the interlayer 220 may include a quantum-dot emission layer, and a first region and a second region may be located on and below the quantum-dot emission layer, respectively. For example, the interlayer 220 may further include the first region located between the pixel electrode 210 and the quantum-dot emission layer, and the second region located between the quantum-dot emission layer and the counter electrode 230. In one or more embodiments, the first region may be a hole transport region, and the second region may be an electron transfer region. In other embodiments, the first region may be an electron transport region, and the second region may be a hole transport region.

The hole transport region may include a hole injection layer, a hole transport layer, an auxiliary layer, or any combinations thereof. The electron transport region may include an electron transport layer, an electron injection layer, an auxiliary layer, or any combinations thereof.

The quantum-dot emission layer may include a quantum dot. The quantum dot is not particularly limited as long as it absorbs and emits light. For example, the quantum dot may include a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound are: a binary compound, such as CdSe, CdTe, ZnS, ZnSe, ZnTe, ZnO, HgS, HgSe, HgTe, MgSe, MgS, and the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and the like; a quaternary compound, such as CdZnSeS, CdZnSeTe, CdZnSTe, CdHgSeS, CdHgSeTe, CdHgSTe, HgZnSeS, HgZnSeTe, HgZnSTe, and the like; or any combination thereof.

Examples of the Group III-V semiconductor compound are: a binary compound, such as GaN, GaP, GaAs, GaSb, AIN, AIP, AlAs, AlSb, InN, InP, InAs, InSb, and the like; a ternary compound, such as GaNP, GaNAs, GaNSb, GaPAs, GaPSb, AINP, AINAs, AINSb, AIPAs, AlPSb, InGaP, InNP, InAlP, InNAs, InNSb, InPAs, InPSb, GaAINP, and the like; a quaternary compound, such as GaAINAs, GaAINSb, GaAIPAs, GaAIPSb, GalnNP, GalnNAs, GaInNSb, GalnPAs, GalnPSb, InAINP, InAINAs, InAINSb, InAIPAs, InAIPSb, and the like; or any combination thereof. The Group III-V semiconductor compound may further include a Group II element. Examples of the Group III-V semiconductor compound further including a Group II element are InZnP, InGaZnP, InAIZnP, and the like

Examples of the Group III-VI semiconductor compound are: a binary compound, such as GaS, GaSe, Ga₂Se₃, GaTe, InS, InSe, In₂S₃, In₂Se₃, InTe, and the like; a ternary compound, such as InGaS₃, InGaSe₃, and the like; or any combination thereof.

Examples of the Group I-III-VI semiconductor compound are: a ternary compound, such as AgInS, AgInS₂, CulnS, CuInS₂, CuGaO₂, AgGaO₂, AgAlO₂, and the like; or any combination thereof.

Examples of the Group IV-VI semiconductor compound are: a binary compound, such as SnS, SnSe, SnTe, PbS, PbSe, PbTe, and the like; a ternary compound, such as SnSeS, SnSeTe, SnSTe, PbSeS, PbSeTe, PbSTe, SnPbS, SnPbSe, SnPbTe, and the like; a quaternary compound, such as SnPbSSe, SnPbSeTe, SnPbSTe, and the like; or any combination thereof.

The Group IV element or compound may include: a single element compound, such as Si, Ge, and the like; a binary compound, such as SiC, SiGe, and the like; or any combination thereof.

Each element included in a multi-element compound, such as the binary compound, the ternary compound, and the quaternary compound, may exist in a particle thereof at a uniform concentration or a non-uniform concentration.

The quantum dot may have: a homogeneous single structure; dual structure, such as a core-shell structure, a gradient structure, and the like; a core-shell-shell triple structure; or a mixed structure thereof. For example, a material included in the core and a material included in the shell may be different from each other.

Examples of the shell of the quantum dot are a metal oxide, a metalloid oxide, a non-metal oxide, a semiconductor compound, or any combination thereof. Examples of the metal oxide, the metalloid oxide, or the non-metal oxide are: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and the like; a ternary compound, such as MgAl₂O₄, CoFe₂O₄, NiFe₂O₄, CoMn₂O₄, and the like; or any combination thereof. Examples of the semiconductor compound are a Group II-VI semiconductor compound, a Group III-V semiconductor compound, a Group III-VI semiconductor compound, a Group I-III-VI semiconductor compound, a Group IV-VI semiconductor compound, or any combination thereof, as described herein.

In an embodiment, the core may include one or more materials selected from CdSe, CdS, InP, InGaP, ZnS, ZnSe, CdTe, CdSeTe, CdZnS, PbSe, AglnZnS, and ZnO, but embodiments of the present disclosure are not limited thereto.

In an embodiment, the shell may include one or more materials selected from CdSe, ZnSe, ZnS, ZnTe, CdTe, PbS, TiO, SrSe, and HgSe, but embodiments of the present disclosure are not limited thereto.

The interlayer 220 may be formed by, for example, a liquid process, for example, an inkjet printing process. For example, the interlayer 220 according to embodiments may be formed by discharging an ink including an organic material and/or quantum dots, onto the pixel electrode 210.

The counter electrode 230 may be arranged on the interlayer 220. The counter electrode 230 may be arranged on the interlayer 220, and may be arranged to cover the entirety of the interlayer 220. In other embodiments, the counter electrode 230 may be arranged on the interlayer 220, for example, may be arranged such as to cover the interlayer 220 and the bank layer 180. The counter electrode 130 may be arranged on the display area (DA), such as to cover the entire display area (DA). That is, the counter electrode 230 may be formed as one on the entire display area (DA) by using an open mask, to cover the plurality of pixels (P) arranged on the display area (DA).

The counter electrode 230 may include a conductive material having low work function. For example, the counter electrode 230 may include a (semi-) transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or alloys thereof. In other embodiments, the counter electrode 230 may further include, on the (semi-) transparent layer including such materials as listed above, a layer such as an ITO, IZO, ZnO, or In₂O₃ layer.

The bank layer 180 is formed using the photosensitive resin composition described above, and a process of diffusing the active component included in the photosensitive resin composition may be further carried out as necessary, and thus, the organic light-emitting diode (LED) may further include the active component diffused from the bank layer 180. The active component may interact with each layer of the light-emitting diode (LED), and thus may facilitate a positive aging effect.

In particular, it was confirmed that when the bank layer is formed using the photosensitive resin composition according to embodiments, there appeared improved current efficiency and quantum efficiency, compared to a case where a bank layer is formed of a photosensitive resin composition not including an active component. Device characteristics of a reference example in which a bank layer was formed using a photosensitive resin composition not including an active component, and an example in which a bank layer was formed using the photosensitive resin composition, according to embodiments, including the active component, were tested, and the results are shown for reference in Table 1. The composition used in the example was the same as the composition used in the reference example, except that 1 part by weight of the active component (a mixture of benzhydrazide, isobutyric acid, and cumene hydroperoxide) with respect to 100 parts by weight of the total compound was included.

**Table 1**

| | Voltage (V @10 mA/cm²) | Driving voltage (V) | Current efficien cy (cd/A) | CIE_x | CIE_y | Quan turn effici ency | λₘₐₓ (nm ) | Full width at half maxim um (nm) |
|---|---|---|---|---|---|---|---|---|
| Reference Example | 11.9 | 12.0 | 17.0 | 0.280 | 0.698 | 4.4 | 540 | 31 |
| Example | 14.4 | 13.9 | 22.1 | 0.277 | 0.701 | 5.8 | 539 | 30 |

In one or more embodiments, the light-emitting diode (LED) may be covered with a thin-film encapsulation layer. The thin-film encapsulation layer may include at least one inorganic encapsulation layer and at least one organic encapsulation layer. In other embodiments, the light-emitting diode (LED) may be covered with an encapsulation substrate.

### [Method of manufacturing display panel]

Hereinafter, a method of manufacturing the display panel 1 described above will be described in order.

A method of manufacturing the display panel 1 according to an embodiment includes: forming a pixel electrode 210 on a substrate 110; forming a bank layer 180 on the pixel electrode 210 by using the photosensitive resin composition described above, the bank layer 180 covering an edge portion of the pixel electrode 210 and including an opening (OP) overlapping the pixel electrode 210; forming an interlayer 220 arranged in the opening (OP) and including a quantum-dot emission layer; and forming a counter electrode 230 on the interlayer, to thereby provide a light-emitting device (LED).

First, a thin-film transistor (TFT, not shown) may be formed on the substrate 100. The pixel electrode 210 may be formed on the thin film transistor (TFT). After the forming of the pixel electrode 210 on the substrate 100, forming the bank layer 180 covering an edge portion of the pixel electrode 210 and having an opening (OP) overlapping the pixel electrode 210 may be further carried out.

In one or more embodiments, the forming of the bank layer 180 may include: forming a photoresist layer on the pixel electrode 210 using the photosensitive resin composition described above; exposing at least a portion of the photoresist layer; and developing the photoresist layer of which at least a portion is exposed, to thereby form the bank layer 180.

In the exposing of the at least a portion of the photoresist layer, at least a portion of the photoresist layer may be exposed with a mask including a light-shielding portion and a light-transmitting portion. A portion of the photoresist layer that overlaps the light-transmitting portion of the mask may be exposed, and the remainder of the photoresist layer that overlaps the light-shielding portion of the mask may not be exposed.

In one or more embodiments, when the photosensitive resin composition is a negative type, the portion overlapping the light-transmitting portion of the mask may form the bank layer 180, and the portion overlapping the light-shielding portion of the mask may form the opening (OP). In other embodiments, when the photosensitive resin composition is a positive type, the portion overlapping the light-transmitting portion of the mask may form the opening (OP), and the portion overlapping the light-shielding portion of the mask may form the bank layer 180.

Furthermore, the method may further include, after the forming of the bank layer 180, baking the bank layer 180. During the baking of the bank layer 180, a liquid-repellent material or a hydrophobic material included in the bank layer 180 may rise to the upper surface 180a of the bank layer 180. Accordingly, the upper surface 180a of the bank layer 180 may have liquid repellency, and the lateral side 180b of the bank layer 180 may not have liquid repellency. In other embodiments, as well as the upper surface 180a of the bank layer 180, the lateral side 180b of the bank layer 180 may have liquid repellency.

In other embodiments, the method may further include, after the forming of the bank layer 180, plasma treatment of the bank layer 180. In other embodiments, the upper surface 180a and/or the lateral side 180b of the bank layer 180 may have liquid repellency by plasma treatment with a fluorine-containing gas.

After the forming of the bank layer 180, the interlayer 220 including the quantum-dot emission layer may be formed on the pixel electrode 210. The interlayer 220 may be formed by, for example, a liquid process, for example, an inkjet printing process. In more particular, an ink for forming the interlayer 220 is discharged onto the pixel electrode 210 from an ink discharge portion including a nozzle, to thereby form the interlayer 220. In particular, the quantum-dot emission layer may be formed through a liquid process, for example, an inkjet printing process.

After the forming of the interlayer 220, the counter electrode 130 may be formed on the interlayer 220, to thereby form the light-emitting diode (LED). The counter electrode 230 may be arranged on the interlayer 220 such as to cover the entire interlayer 220. In other embodiments, the counter electrode 230 may be arranged on the interlayer 220 such as to cover the interlayer 220 and the bank layer 180. That is, the counter electrode 230 may be formed as one on the entire display area (DA) by using an open mask, to cover the plurality of pixels (P) arranged on the display area (DA).

Although not illustrated, the light-emitting diode (LED) may be covered with a thin film encapsulation layer. The thin-film encapsulation layer may include at least one inorganic encapsulation layer and at least one organic encapsulation layer. In other embodiments, the light-emitting diode (LED) may be covered with an encapsulation substrate.

After the provision of the light-emitting diode (LED), the method may further comprise diffusing the active component included in the photosensitive resin composition from the bank layer 180 into the light-emitting diode (LED). Due to this, the light-emitting diode (LED) may comprise the active component diffused from the bank layer 180. The active component may interact with each layer of the light-emitting diode (LED), and thus may facilitate a positive aging effect.

In one or more embodiments, the diffusing of the active component may be carried out in a temperature range from 50 °C to 100 °C.

In one or more embodiments, the diffusing of the active component may be carried out in a time range from 2 hours to 48 hours.

In one or more embodiments, the diffusing of the active component may be carried out in an environment under a non-inert atmosphere, for example, in an oxygen and/or hydrogen atmosphere.

While one or more embodiments have been described with reference to the figures, it will be understood by those of ordinary skill in the art that various changes in form and details may be made therein without departing from the spirit and scope as defined by the following claims.

## Claims

1. A photosensitive resin composition comprising:
a binder resin; a photopolymerizable monomer; a photopolymerization initiator; an active component; and a solvent,
wherein the active component comprises acyl hydrazide, alkyl carboxylic acid, organic hydroperoxide, or any combination thereof.

2. The photosensitive resin composition of claim 1, wherein the active component comprises benzhydrazide, isobutyric acid, cumene hydroperoxide, or any combination thereof.

3. The photosensitive resin composition of claim 1, wherein an amount of the active component is in a range of about 0.1 parts to about 1 part by weight based on 100 parts by weight of the photosensitive resin composition.

4. The photosensitive resin composition of claim 1, further comprising a liquid-repellent material.

5. A display panel comprising:
a light-emitting device on a substrate; and a bank layer prepared using the photosensitive resin composition of claim 1,
wherein the light-emitting device comprises a pixel electrode, an interlayer arranged on the pixel electrode and comprising a quantum-dot emission layer, and a counter electrode on the interlayer,
the bank layer covers an edge portion of the pixel electrode and includes an opening overlapping the pixel electrode, and
the interlayer is arranged in the opening.

6. The display panel of claim 5, wherein the counter electrode covers the interlayer and the bank layer.

7. The display panel of claim 5, wherein the interlayer further comprises:
a first region located between the pixel electrode and the quantum-dot emission layer; and a second region located between the quantum-dot emission layer and the counter electrode,
wherein the first region is a hole transport region and the second region is an electron transport region, or
the first region is an electron transport region and the second region is a hole transport region.

8. The display panel of claim 5, wherein the light-emitting device comprises the active component diffused from the bank layer.

9. The display panel of claim 5, wherein an upper surface and/or a lateral side of the bank layer have liquid repellency.

10. The display panel of claim 5, wherein the quantum-dot includes a Group II-VI semiconductor compound, a Group III-V semiconductor compound, a Group III-VI semiconductor compound, a Group I-III-VI semiconductor compound, a Group IV-VI semiconductor compound, a Group IV element or compound, or any combination thereof.

11. A method of manufacturing a display panel, the method comprising:
forming a pixel electrode on a substrate;
forming a bank layer on the pixel electrode by using the photosensitive resin composition of claim 1, the bank layer covering an edge portion of the pixel electrode and including an opening overlapping the pixel electrode;
forming an interlayer arranged in the opening and comprising a quantum-dot emission layer; and
forming a counter layer on the interlayer, to thereby provide a light-emitting diode.

12. The method of claim 11, further comprising, after the providing of the light-emitting diode, diffusing the active component from the bank layer into the light-emitting diode.

13. The method of claim 12, wherein the diffusing of the active component is carried out in a temperature range of about 50 °C to about 100 °C.

14. The method of claim 12, wherein the diffusing of the active component is carried out in a time range of about 2 hours to about 38 hours.

15. The method of claim 12, wherein the diffusing of the active component is carried out in an oxygen and/or hydrogen atmosphere.

16. The method of claim 11, wherein the forming of the bank layer comprises:
forming a photoresist layer on the pixel electrode by using the photosensitive resin composition of claim 1;
exposing at least a portion of the photoresist layer; and
developing the photoresist layer of which at least a portion is exposed, to thereby form the bank layer.

17. The method of claim 11, further comprising, after the forming of the bank layer, baking the bank layer.

18. The method of claim 11, further comprising, after the forming of the bank layer, plasma treatment of the bank layer.

19. The method of claim 11, wherein the quantum-dot emission layer is formed by a solution process.

20. The method of claim 11, wherein the quantum-dot emission layer is formed by inkjet printing.
